# EUROPEAN PATENT APPLICATION

(11) **EP 4 852 686 A1**
(43) Date of publication of application: **09.12.2026**
(21) Application number: 26161950.6
(22) Date of filing: 03.03.2026
(51) Int. Cl.: H10K 77/10

(54) **DISPLAY DEVICE AND ELECTRONIC DEVICE COMPRISING DISPLAY DEVICE**

(30) Priority: 02.06.2025 KR 20250072434
(71) Applicant: Samsung Display Co., Ltd., Yongin-si, Gyeonggi-do 17113 (KR)
(72) Inventor: MA, Hyung Gun, 17113 Yongin-si (KR)
(74) Representative: Marks & Clerk LLP

(57) **Abstract**

According to one or more embodiments of the present disclosure, a display device, a method of manufacturing the display device, and an electronic device comprising the display device may be provided. The display device comprises: an insulating portion, functioning as an alignment key and comprising an insulating material.

## Description

### BACKGROUND

### 1. Field

One or more embodiments of the present disclosure described herein relate to a display device, a method for manufacturing the display device, and an electronic device including the display device.

### 2. Description of the Related Art

Research and development of display devices have been continuously conducted or pursued in response to the growing interest in information display technologies in recent years. Such display devices may be applied to one or more suitable types (kinds) of electronic devices.

Display devices are, for example, manufactured through a plurality (a series) of processes. To ensure that these processes are performed accurately, it is desirable to clearly identify the positions of the layers to be processed.

The information disclosed in this Background section is intended to enhance (facilitate) understanding of the context of the present disclosure and may contain information that does not constitute prior art.

### SUMMARY

Aspects according to one or more embodiments of the present disclosure are directed toward a display device, a method of manufacturing the display device, and an electronic device including the display device, wherein the positions of cells included in a mother substrate during a process may be clearly identified.

Aspects according to one or more embodiments of the present disclosure are directed toward a display device, a method of manufacturing the display device, and an electronic device including the display device, wherein the design flexibility for the layers on the substrate may be enhanced, the layers may be efficiently patterned within a space, and the integration density of layers on the substrate may be improved.

Additional aspects of embodiments will be set forth in part in the description which follows and, in part, will be apparent from the description, or may be learned by practice of the presented embodiments of the disclosure.

According to one or more embodiments of the present disclosure, a display device includes: an insulating portion, functioning as an alignment key and including an insulating material.

According to one or more embodiments, the display device may include: an alignment key area; and an alignment key peripheral area around (e.g., surrounding) at least a portion of the alignment key area. The insulating portion may be positioned or otherwise arranged (e.g., positioned) in the alignment key area.

According to one or more embodiments, the alignment key area may be entirely surrounded by the alignment key peripheral area and has an isolated shape.

According to one or more embodiments, the insulating portion may have a shape covering an area and has a visually identifiable shape.

According to one or more embodiments, the display device may further include: a substrate; and a conductive layer on the substrate. At least a portion of the insulating portion may be recessed into the substrate in a thickness direction of the substrate.

According to one or more embodiments, the conductive layer may include a reflective conductive material and is arranged to overlap the insulating portion in a plan view.

According to one or more embodiments, the conductive layer may be arranged (e.g., positioned) over the alignment key area and the alignment key peripheral area.

According to one or more embodiments, the display device may further include: an upper reflective layer on (e.g., arranged on) the conductive layer. The conductive layer may include a plurality of layers. The insulating portion may overlap at least one of the upper reflective layer and the conductive layer in a plan view.

According to one or more embodiments, the conductive layer may include copper and the upper reflective layer may include aluminium.

According to one or more embodiments, the substrate may include a base portion around (e.g., surrounding) at least a portion of the insulating portion and forming a base of the substrate. The base portion may include a silicon material, and does not include silicon oxide. The insulating portion may include a silicon oxide.

According to one or more embodiments, the insulating portion may be to transmit light having a wavelength of 1150 nm or less. The base portion may be to absorb the light.

According to one or more embodiments, the display device may further include: an insulating layer directly covering at least a portion of the base portion. An upper surface of the insulating portion may be in contact with the insulating layer.

According to one or more embodiments, the display device may further include a dummy pattern portion arranged (e.g., positioned) in the alignment key peripheral area. The insulating portion and the dummy pattern portion may include a same insulating material.

According to one or more embodiments, an upper surface of the base portion may be not completely covered by the dummy pattern portion in the alignment key peripheral area.

According to one or more embodiments, the dummy pattern portion may form a mesh structure in a plan view.

According to one or more embodiments, the display device may further include: a sub-pixel circuit on the substrate; and a light-emitting element electrically connected to the sub-pixel circuit. At least a portion of the conductive layer arranged (e.g., positioned) in the alignment key area may form at least a portion of a circuit element of the sub-pixel circuit and at least a portion of a wiring electrically connected to the sub-pixel circuit.

According to one or more embodiments, the substrate may further include trench insulating portions and a well between the trench insulating portions. The well may form (define) a source area, a drain area, and a channel area of the circuit element. The trench insulating portions may include a same material as the insulating portion.

According to one or more embodiments, the trench insulating portions may extend longer in a downward direction relative to the well.

According to one or more embodiments of the present disclosure, a display device includes: a substrate including silicon, an alignment key being embedded in the substrate; and a light-emitting element on the substrate, including an organic light-emitting element.

According to one or more embodiments of the present disclosure, an electronic device includes: a processor and a display device configured to receive image data from the processor, the display device comprising an insulating portion configured to function as an alignment key and comprising an insulating material.

At least some of the above and other features of the invention are set out in the claims.

According to one or more embodiments of the present disclosure, there may be provided a display device, a method of manufacturing the display device, and an electronic device including the display device, wherein the positions of cells included in a mother substrate during a process may be clearly identified.

According to one or more embodiments of the present disclosure, there may be provided a display device, a method of manufacturing the display device, and an electronic device including the display device, wherein the design flexibility for the layers on the substrate may be enhanced, the layers may be efficiently patterned within a space, and the integration density of layers on the substrate may be improved.

For example, in accordance with one or more embodiments of the present disclosure, the display device may include an alignment key area and an alignment key peripheral area that facilitates precise layer positioning during manufacturing. The arrangement of insulating portions within the alignment key area may serve as reference points for cell alignment and substrate processing. Additionally, the integration of patterned layers, such as sub-pixels arranged in a PenTile^{®} configuration and electrodes including capping layers, contributes to improved design flexibility, spatial efficiency, and optical performance. These and other features described herein provide structural and functional enhancements for advance display devices and associated electronic devices and manufacturing methods.

### BRIEF DESCRIPTION OF THE DRAWINGS

FIG. 1 is a schematic plan view illustrating a display device according to one or more embodiments.
FIG. 2 is a schematic exploded perspective view illustrating a display device according to one or more embodiments.
FIG. 3 is a schematic cross-sectional view illustrating a display panel according to one or more embodiments.
FIG. 4 is a schematic cross-sectional view illustrating a display panel, according to one or more embodiments.
FIG. 5 is a schematic plan view illustrating a portion of a peripheral area, according to one or more embodiments.
FIG. 6 is a schematic cross-sectional view illustrating a display panel in a display area, according to one or more embodiments.
FIG. 7 is a schematic cross-sectional view illustrating a display panel in a peripheral area, according to one or more embodiments.
FIG. 8 is a schematic plan view illustrating some process steps of a method of manufacturing a display device, according to one or more embodiments.
FIG. 9 is a schematic cross-sectional view illustrating some process steps of a method of manufacturing a display device, according to one or more embodiments.
FIG. 10 is a schematic plan view illustrating some process steps of a method of manufacturing a display device, according to one or more embodiments.
FIG. 11 is a schematic cross-sectional view illustrating some process steps of a method of manufacturing a display device, according to one or more embodiments.
FIG. 12 is a block diagram of an electronic device according to one or more embodiments.
FIG. 13 contains drawings illustrating one or more embodiments of the electronic device.

### DETAILED DESCRIPTION

As the present disclosure may be subject to one or more suitable modifications and may have one or more suitable forms, specific embodiments are to be illustrated in the drawings and described in more detail in the specification. However, this is not intended to limit the present disclosure to the specific disclosed forms, and it should be understood to include all modifications, equivalents, or substitutes that are included within the technical scope of the present disclosure.

Terms such as "first", "second", and/or the like., may be used to describe one or more suitable components, but the said components should not be limited by the said terms. The said terms are only used for the purpose of distinguishing one component from another. For example, without departing from the scope of the rights of the present disclosure, a first component may be named a second component, and similarly, a second component may also be named a first component. A singular expression includes a plural expression unless the context clearly indicates otherwise.

In the present disclosure, if (e.g., when) a part such as a layer, film, region, or plate is referred to as being "on" another part, this includes not only the case where it is "directly on" the other part but also the case where another part is present in between. Furthermore, in this specification, if (e.g., when) a part such as a layer, film, region, or plate is described as being formed "on" another part, the direction of formation is not limited to only the upward direction and includes formation in a lateral or downward direction. Conversely, if (e.g., when) a part such as a layer, film, region, or plate is referred to as being "under" another part, this includes not only the case where it is "directly under" the other part but also the case where another part is present in between.

In the context of the present disclosure and unless otherwise defined, a plan view is an orthographic projection of a three-dimensional object from the position of a horizontal plane intersecting the object. That is, it is a top-down view, showing the layout and spatial relationships of various elements within the object or structure. A plan view based on a z-axis (thickness or direction DR3) direction refers to a top-down view of the object, as if looking directly down onto the surface from above. In this context, the z-axis direction is perpendicular or normal to the horizontal plane defined by x-axis and y-axis directions (e.g., DR1 and DR2 directions).

The utilization of "may" when describing embodiments of the present disclosure refers to "one or more embodiments of the present disclosure."

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value. Also, it should be understood that, even if the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

In the context of the present application and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The light-emitting element, the display apparatus/device, the electronic apparatus/device, the manufacturing apparatuses thereof, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In the present disclosure, each suitable feature of the various embodiments of the disclosure may be combined or combined with each other, partially or entirely, and may be technically interlocked and operated in various suitable ways, and each embodiment may be implemented independently of each other or in conjunction with each other in any suitable manner unless otherwise stated or implied.

In the present disclosure, it will be understood that the term "comprise(s)/comprising," "include(s)/including," or "have/has/having" specifies the presence of stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having", or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

The present disclosure relates to a display device, a method of manufacturing the display device, and an electronic device including the display device. Hereinafter, with reference to the accompanying drawings, a display device, a method of manufacturing the display device, and an electronic device including the display device will be described according to one or more embodiments.

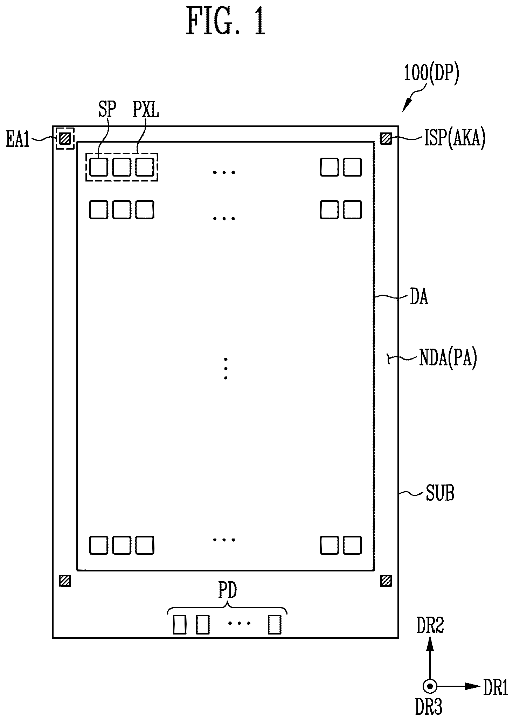

FIG. 1 is a schematic plan view illustrating a display device according to one or more embodiments.

The display device 100 may include a display panel DP. The display device 100 (or display panel DP) includes sub-pixels SP. The sub-pixels SP may be arranged in a zigzag pattern along a row direction and a column direction. For example, the sub-pixels SP may be arranged in a PenTile^{®} configuration in which the sub-pixels SP are arranged in a rhombic shape. PenTile^{®} is a duly registered trademark of Samsung Display Co., Ltd. However, embodiments are not limited to this. For example, the sub-pixels SP may be arranged in a matrix form along the row and column directions.

Each of the sub-pixels SP may include at least one light-emitting element configured to generate light. Accordingly, each of the sub-pixels SP may be configured to generate light of a particular color, such as red, green, blue, cyan, magenta, yellow, and/or the like. A unit of two or more sub-pixels SP may be provided as a single pixel PXL. Accordingly, a pixel PXL may emit light of one or more suitable colors. As such, the display device 100 displays the image through the sub-pixels SP.

The display device 100 (or display panel DP) may include a display area DA and a non-display area NDA. The display panel DP displays the image through the display area DA. The non-display area NDA is arranged around the periphery of the display area DA. According to one or more embodiments, the non-display area NDA may be a peripheral area PA.

The display device 100 (or display panel DP) may include a substrate SUB and pads PD.

The display device 100 (or display panel DP) may be used as a display screen for a virtual reality (VR) device, a mixed reality (MR) device, an augmented reality (AR) device, and/or the like. For example, the display device 100 (or display panel DP) may be used as a display screen for a head-mounted display (HMD). In such cases, a relatively high density of sub-pixels SP may be desired or required. To increase the integration of the sub-pixels SP, the sub-pixels SP may be formed on a silicon substrate. A display device 100 including sub-pixels SP formed on a silicon substrate may be referred to as an OLED on Silicon (OLEDoS) display device.

The sub-pixels SP are arranged (e.g., formed) in a display area DA on a substrate SUB. The sub-pixels SP may be arranged in a matrix form along a first direction DR1 and a second direction DR2 intersecting the first direction DR1. However, embodiments are not limited to this. For example, the sub-pixels SP may be arranged in a zigzag pattern along the first direction DR1 and the second direction DR2. For example, the sub-pixels SP may be arranged in a PenTile^{®} configuration in which the sub-pixels SP are arranged in a rhombic shape. PenTile^{®} is a duly registered trademark of Samsung Display Co., Ltd. The first direction DR1 may be in the row direction and the second direction DR2 may be in the column direction.

Two or more sub-pixels SP of the plurality of sub-pixels SP may form a single pixel PXL.

Components for controlling the sub-pixels SP may be arranged in the non-display area NDA on the substrate SUB. For example, wiring lines electrically connected to the sub-pixels SP, such as gate lines and data lines, may be arranged in the non-display area NDA.

Pads PD may be arranged in the non-display area NDA on the substrate SUB. The pads PD may be electrically connected to the sub-pixels SP via one or more suitable wiring lines. For example, the pads PD may be connected to the sub-pixels SP via the data lines.

The pads PD may interface the display panel DP to other components of the display device 100. According to one or more embodiments, voltages and signals desired or required for the operation of components included in the display panel DP may be provided through the pads PD from driver integrated circuits included in the display device 100.

According to one or more embodiments, the display area DA may have one or more suitable shapes. The display area DA may have a shape of a closed loop including straight and/or curved sides. For example, in one or more embodiments, the display area DA may have the shape of a polygon, circle, semicircle, ellipse, and/or the like.

According to one or more embodiments, the display panel DP may have a flat display surface. In one or more embodiments, the display panel DP may have a display surface that is at least partially rounded. According to one or more embodiments, the display panel DP may be bendable, foldable, or rollable. The display panel DP and/or the substrate SUB may include materials having flexible properties.

According to one or more embodiments, the display device 100 (or display panel DP) may include an alignment key area AKA and an insulating portion ISP arranged in the alignment key area AKA.

The alignment key area AKA may be formed adjacent to the display area DA. The alignment key area AKA may be arranged in the peripheral area PA.

The alignment key area AKA may be an area where the insulating portion ISP may be configured to be visually identifiable.

The insulating portion ISP formed in the alignment key area AKA may function as an alignment key.

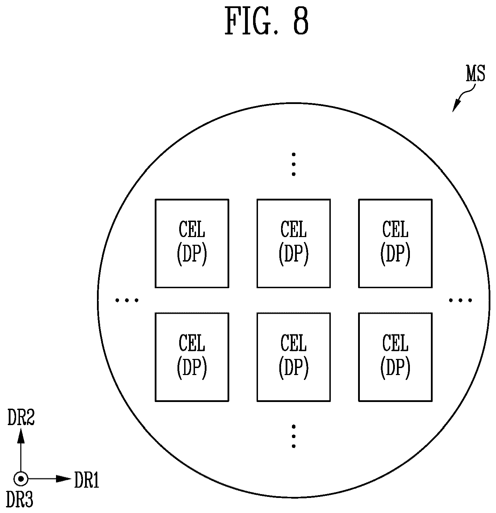

The insulating portion ISP may be patterned and/or formed in a set or predetermined location. A position of the insulating portion ISP may function as a reference point for determining the respective position of the plurality of cells CEL if (e.g., when) the mother substrate MS (see FIG. 8), including the plurality of cells CEL, is cut. For example, the position of the insulating portion ISP may serve as a reference point for determining the respective positions of the plurality of cells CEL, particularly during separation or cutting of the mother substrate MS.

An insulating portion ISP (or alignment key area AKA) may be arranged (or formed) in a peripheral area PA (or non-display area NDA). The insulating portion ISP (or alignment key area AKA) may be arranged in an edge of the display panel DP.

For example, the insulating portion ISP (or alignment key area AKA) may be arranged adjacent to a corner of the display area DA. According to one or more embodiments, the insulating portion ISP (or alignment key areas AKA) may be arranged adjacent to each of the corners of the display area DA, but the present disclosure is not limited thereto. The areas in which the insulating portion ISP (or alignment key areas AKA) are arranged may be varied.

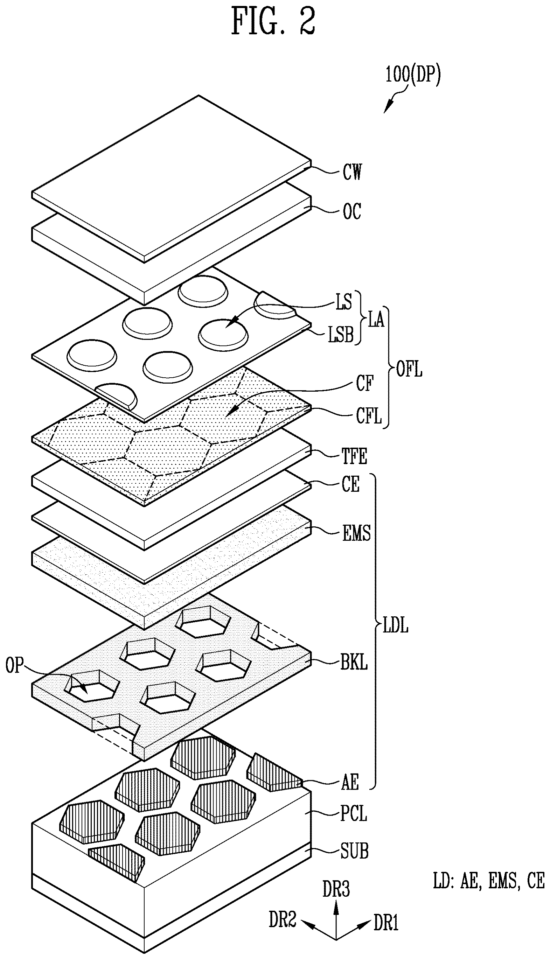

FIG. 2 is a schematic exploded perspective view illustrating a display device according to one or more embodiments. In FIG. 2, for clarity and simplicity, a portion of the display device 100 corresponding to some of the sub-pixels SP of FIG. 1 is shown schematically. A portion of the display device 100 corresponding to the remaining sub-pixels SP may be similarly formed.

The display device 100 (or display panel DP) may include a substrate SUB, a pixel circuit layer PCL, a light-emitting element layer LDL, an encapsulation layer TFE, an optical functional layer OFL, an overcoat layer OC, and a cover window CW.

A pixel circuit layer PCL is arranged on the substrate SUB. The pixel circuit layer PCL may include a sub-pixel circuit electrically connected to the sub-pixel SP. The conductive patterns and semiconductor patterns included in the substrate SUB and/or the pixel circuit layer PCL may function as circuit elements. The circuit elements may be included in sub-pixel circuits corresponding to the sub-pixels SP. The wiring of the pixel circuit layer PCL may include signal lines connected to the sub-pixel circuits, such as gate lines, light emission control lines, data lines, pre-voltage lines, and/or the like. The wiring of the pixel circuit layer PCL may further include one or more suitable power wiring.

The light-emitting element layer LDL may include anode electrodes AE, a bank layer BKL, an emission structure EMS, and a cathode electrode CE.

The anode electrodes AE are arranged on the pixel circuit layer PCL. The anode electrodes AE may be electrically connected to circuit elements of the pixel circuit layer PCL. The anode electrodes AE may include an opaque conductive material configured to reflect light, but embodiments are not limited thereto.

In FIG. 2, anode electrodes AE having a hexagonal shape are shown in one or more embodiments. However, embodiments are not limited thereto. The anode electrodes AE may be shaped into one or more suitable other shapes, such as circular, rectangular, and/or the like.

A bank layer BKL is arranged on the anode electrodes AE. The bank layer BKL may include openings OP overlapping each of the anode electrodes AE. The openings OP may expose portions of the anode electrodes AE. The openings OP in the bank layer BKL may define emission areas corresponding to sub-pixels SP. In areas adjacent to the edges of the anode electrodes AE, the bank layer BKL may include separators that cause a discontinuity to form in the emission structure EMS. In such cases, it may be understood that the separators in the bank layer BKL define the emission areas corresponding to the sub-pixels SP.

In FIG. 2, openings OP having a hexagonal shape are illustrated. However, embodiments are not limited thereto. The openings OP may be shaped as circular, rectangular, or other shapes.

The emission structure EMS may be arranged on the bank layer BKL. The emission structure EMS may include a light-emitting layer configured to generate light, an electron transport layer configured to transport electrons, and a hole transport layer configured to transport holes.

The emission structure EMS may be arranged on the anode electrodes AE by filling the openings OP in the bank layer BKL, and may be arranged entirely on an upper portion of the bank layer BKL. The emission structures EMS may be arranged entirely across the sub-pixels SP. At least some of the layers in the emission structure EMS may be broken or bent at the boundaries between the sub-pixels SP due to the separators in the bank layer BKL. However, embodiments are not limited thereto. For example, light-emitting layers may be arranged on anode electrodes AE in the openings OP. Each of the light-emitting layers may be configured to emit light in one of the following colors: red, green, blue, and/or the like.

A cathode electrode CE may be arranged on the emission structure EMS. The cathode electrode CE may be a common electrode for the sub-pixels SP.

The cathode electrode CE may be a thin metal layer having a thickness sufficient to transmit light emitted from the emission structure EMS. The cathode electrode CE may be formed of a metallic material to have a relatively small thickness or may be formed of a transparent conductive material. According to one or more embodiments, the cathode electrode CE may include at least one or more suitable transparent conductive materials, including indium tin oxide, indium zinc oxide, indium tin zinc oxide, aluminium zinc oxide, gallium zinc oxide, zinc tin oxide, and/or gallium tin oxide. In other embodiments, the cathode electrode CE may include silver (Ag), magnesium (Mg), or a mixture thereof. According to one or more embodiments, the cathode electrode CE may have a multilayer structure. For example, the cathode electrode CE may include a first layer including an indium zinc oxide and a second layer including a silver (Ag) magnesium (Mg) alloy. In one or more embodiments, the cathode electrode CE may further include a capping layer on top of the first and second layers, which functions to direct light toward the front surface of the display panel DP. For example, the capping layer is arranged over the first and second layers, configured to redirect emitted light toward the viewing surface of the display panel DP. However, embodiments are not limited thereto.

It may be understood that any of the anode electrodes AE, a portion of the emission structure EMS overlapping thereon, and a portion of the cathode electrode CE overlapping thereon forming a light-emitting element LD. The light-emitting element LD may include an organic light-emitting diode.

An encapsulation layer TFE is arranged on the cathode electrode CE. The encapsulation layer TFE may cover the light-emitting element layer LDL and the pixel circuit layer PCL. The encapsulation layer TFE may be configured to prevent or reduce oxygen and moisture from penetrating into the light-emitting element layer LDL. According to one or more embodiments, the encapsulation layer TFE may include a structure of alternating layers of one or more inorganic films and one or more organic films. For example, the inorganic films may include silicon nitride, silicon oxide, and/or silicon oxynitride (SiOxNy). For example, the organic film may include an acrylic resin, epoxy resin, phenol resin, polyamide resin, polyimide resin, unsaturated polyester resin, polyphenylenether resin, polyphenylenesulfide resin, benzocyclobutene (BCB) resin, and/or the like. However, the organic and inorganic materials of the encapsulation layer TFE are not limited thereto.

To improve the sealing efficiency of the encapsulation layer TFE, the encapsulation layer TFE may further include a thin film including aluminium oxide (AlOx). A thin film including the aluminium oxide may be arranged on the upper surface of the encapsulation layer TFE opposite to (e.g., facing) the optical functional layer OFL and/or on the bottom surface of the encapsulation layer TFE opposite to (e.g., facing) the light-emitting element layer LDL.

The thin film including aluminium oxide may be formed by an Atomic Layer Deposition (ALD) method. However, embodiments are not limited thereto. The encapsulation layer TFE may further include a thin film formed from at least one of a variety of materials suitable for improving packaging efficiency.

An optical functional layer OFL is arranged on the encapsulation layer TFE. The optical functional layer OFL may include a color filter layer CFL and a lens array LA.

The color filter layer CFL is arranged between the encapsulating layer TFE and the lens array LA. The color filter layer CFL is configured to filter light emitted from the emission structure EMS to selectively output light of a wavelength range or color corresponding to each sub-pixel SP. The color filter layer CFL may include a plurality of color filters CF each overlapping the openings OP. Each of the color filters CF may pass light in a wavelength range corresponding to a sub-pixel SP. For example, a first color filter may pass red colored light, a second color filter may pass blue colored light, and a third color filter may pass green colored light. Depending on the light emitted from the emission structure EMS of each sub-pixel SP, at least some of the color filters CF may not be provided.

The color filters CF may have a same shape as the openings OP. However, embodiments are not limited thereto, and the color filters CF may be varied in shape.

According to one or more embodiments, in the area between neighboring color filters CF, the materials of the neighboring color filters CF may overlap. In such cases, the overlap of the neighboring color filters CF may function as a light-shielding layer.

The sub-pixel circuit of the pixel circuit layer PCL, the light-emitting element LD of the light-emitting element layer LDL, and the color filter CF corresponding to the light-emitting element LD may form a sub-pixel SP.

The lens array LA is arranged on the color filter layer CFL. The lens array LA may include a base layer LSB extending along the first and second directions DR1, DR2, and lenses LS arranged on the base layer LSB. The lenses LS may each be overlapped on a color filter CF. Each of the lenses LS may direct light emitted from the emission structure EMS to an intended path, thereby improving light emission efficiency. According to one or more embodiments, the lenses LS may include organic materials. According to one or more embodiments, the lenses LS may include an acrylic material. However, the materials of the lenses LS are not limited thereto.

In FIG. 2, lenses LS having a circular shape are illustrated in one or more embodiments. Each of the lenses LS may have a trapezoidal shape if (e.g., when) viewed in cross-section. However, embodiments are not limited thereto. The lenses LS may be shaped in a variety of ways. For example, each of the lenses LS may have a polygonal shape in a plan view, a semicircular shape if (e.g., when) viewed in cross-section, or a rounded shape.

The lenses LS may be arranged on the base layer LSB, but may be integrally formed with the base layer LSB. For example, the base layer LSB and the lenses LS may include a same material. However, embodiments are not limited thereto. For example, the base layer LSB may not be provided.

The overcoat layer OC may be arranged on the lens array LA. The overcoat layer OC may cover the optical functional layer OFL, the encapsulation layer TFE, the emission structure EMS, and/or the pixel circuit layer PCL. The overcoat layer OC may include a variety of materials suitable for protecting the layers beneath it from contaminants, such as dust, moisture, and/or the like. For example, the overcoat layer OC may include at least one of an inorganic insulating film and/or an organic insulating film. For example, in one or more embodiments, the overcoat layer OC may include epoxy, but embodiments of the present disclosure are not limited thereto.

The cover window CW may be arranged on the overcoat layer OC. The cover window CW is configured to protect the layers beneath it. The cover window CW may include glass, but embodiments are not limited thereto. For example, the cover window CW may be an encapsulation glass configured to protect components arranged beneath it. In other embodiments, the cover window CW may not be provided.

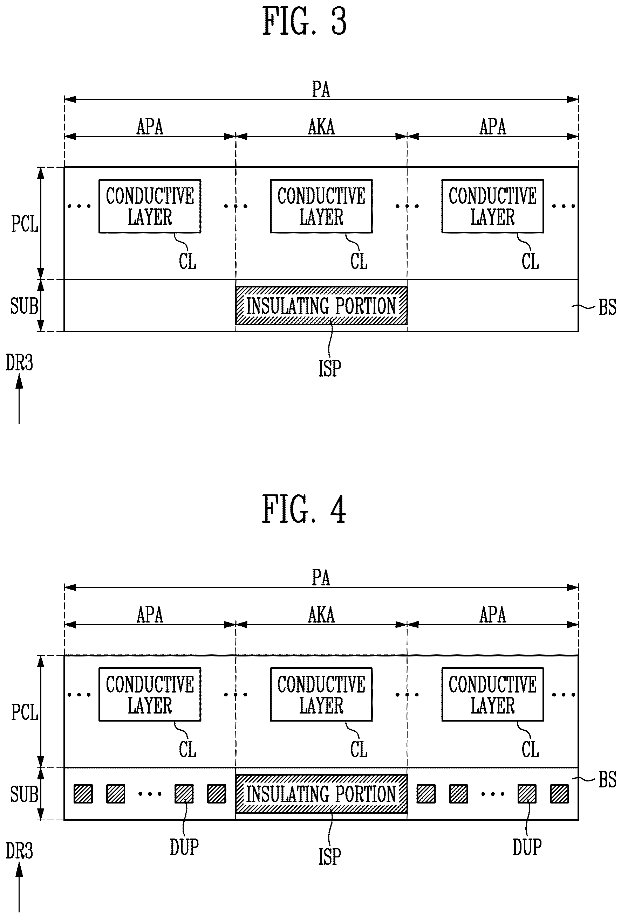

Referring to FIGS. 3-7, a display device 100 including an insulating portion ISP formed in an alignment key area AKA according to one or more embodiments will be described in more detail. For ease of description, any details that may be redundant to the foregoing will be briefly described or not repeated.

FIG. 3 is a schematic cross-sectional view illustrating a display panel according to one or more embodiments. FIG. 4 is a schematic cross-sectional view of a display panel according to one or more embodiments. FIG. 4 schematically illustrates a dummy pattern portion DUP if (e.g., when) compared to FIG. 3.

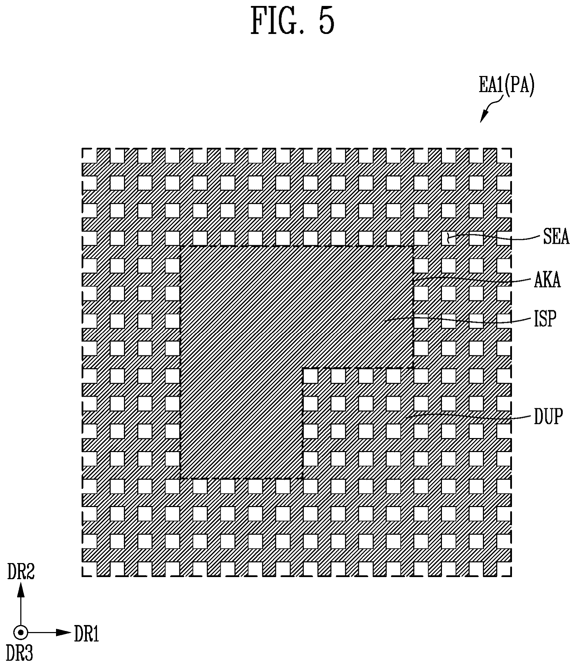

FIG. 5 is a schematic plan view illustrating a portion of a peripheral area according to one or more embodiments. FIG. 5 is a schematic enlargement of the EA1 area of FIG. 1.

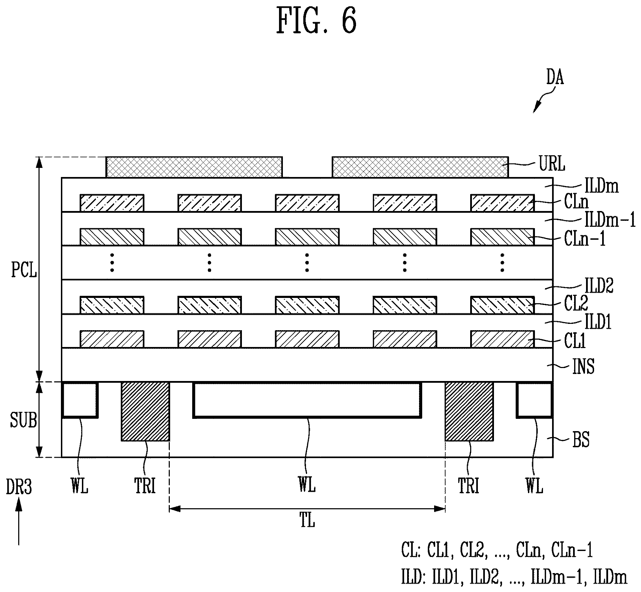

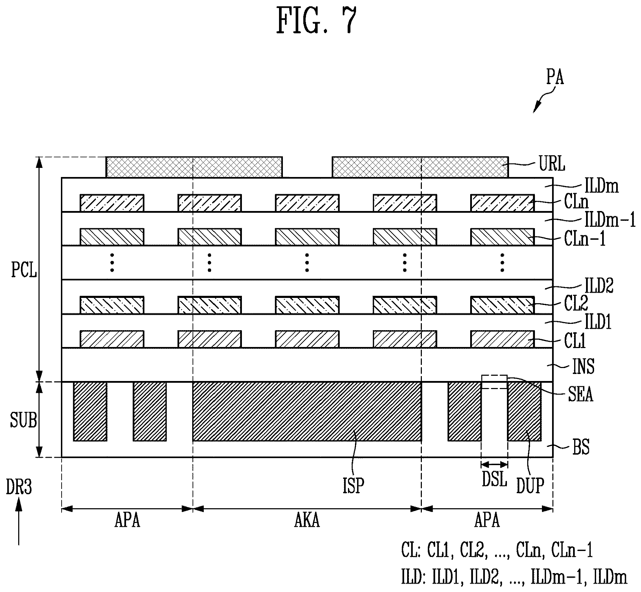

FIG. 6 is a schematic cross-sectional view illustrating a display panel in a display area, according to one or more embodiments. FIG. 6 schematically illustrates a portion of an area where wells WL are arranged, in accordance with one or more embodiments. FIG. 7 is a schematic cross-sectional view illustrating a display panel in a peripheral area, according to one or more embodiments. FIG. 7 schematically illustrates a portion of an area where an insulating portion ISP is arranged, according to one or more embodiments.

Referring to FIG. 3, a display panel DP (or display device 100) according to one or more embodiments may include a cross-sectional structure including a substrate SUB and a pixel circuit layer PCL in a peripheral area PA.

According to one or more embodiments, the substrate SUB may include an alignment key embedded therein. The substrate SUB may include a structure configured to perform the function of the alignment key.

For example, the substrate SUB may include an insulating portion ISP. The insulating portion ISP may be on a portion of the substrate SUB. According to one or more embodiments, at least a portion of the insulating portion ISP may be recessed into the interior of the substrate SUB in a thickness direction of the substrate SUB (e.g., third direction DR3). Accordingly, space utilization on the substrate SUB may be improved.

The display panel DP (or display device 100) may include an alignment key area AKA and an alignment key peripheral area APA. In the peripheral area PA, the alignment key area AKA and the alignment key peripheral area APA may be adjacent to each other (e.g., directly adjacent). The alignment key peripheral area APA may enclose at least a portion of the alignment key area AKA.

The insulating portion ISP may overlap the base portion BS in a direction extending from the plane in which the substrate SUB is arranged (e.g., horizontally). For example, the insulating portion ISP may overlap along the horizontal direction with a portion of the base portion BS arranged in the alignment key peripheral area APA.

According to one or more embodiments, the insulating portion ISP may include an insulating material. For example, the insulating portion ISP may form an alignment key structure and may not include a conductive material (e.g., a metallic material).

According to one or more embodiments, the pixel circuit layer PCL may include a conductive layer CL including one or more suitable conductive materials.

According to one or more embodiments, the conductive layer CL may include a reflective conductive material. For example, the conductive layer CL may include at least one of copper, silver, aluminium, nickel, gold, palladium, molybdenum, or platinum. However, the present disclosure is not limited thereto.

The conductive layer CL may be arranged in an alignment key area AKA and an alignment key peripheral area APA. At least a portion of the conductive layer CL may be arranged across the alignment key area AKA and the alignment key peripheral area APA. According to one or more embodiments, at least a portion of the conductive layer CL arranged in the alignment key area AKA may form at least a portion of the circuit elements of the sub-pixel circuit and/or at least a portion of the wiring electrically connected to the sub-pixel circuit.

According to one or more embodiments, the conductive layer CL may overlap the insulating portion ISP in a plan view. At least a portion of the conductive layer CL may overlap the insulating portion ISP along the third direction DR3, which is the thickness direction of the substrate SUB. For example, at least a portion of the conductive layer CL may overlap both (e.g., simultaneously) the insulating portion ISP arranged in the alignment key area AKA and at least a portion of the base portion BS arranged in the alignment key area AKA.

Referring to FIG. 4, according to one or more embodiments, the substrate SUB may further include a dummy pattern portion DUP.

According to one or more embodiments, the dummy pattern portion DUP may be arranged in the peripheral area PA. For example, at least a portion of the dummy pattern portion DUP may be arranged in the alignment key peripheral area APA.

The dummy pattern portion DUP may include (e.g., may be formed from) a same insulating material as the insulating portion ISP. According to one or more embodiments, the dummy pattern portion DUP may be included (e.g., may be formed) in a same process as the insulating portion ISP, but the present disclosure is not limited thereto.

The dummy pattern portion DUP may include a plurality of portions, the plurality of portions being spaced apart by an interval. The spacing distance between the dummy pattern portions DUP formed in the peripheral area PA may be similar to or substantially identical to the spacing distance between the trench insulating portions TRI (see FIG. 6) arranged in the display area DA. Accordingly, the insulating portions formed on the substrate SUB across the display area DA and the peripheral area PA may be arranged in a generally similar structure.

Referring to FIG. 5, a planar structure in which an insulating portion ISP is formed in the peripheral area PA to form an alignment key area AKA is disclosed.

According to one or more embodiments, the alignment key area AKA may have an isolated shape in the peripheral area PA. For example, the alignment key area AKA may be surrounded by other areas of the peripheral area PA other than the alignment key area AKA. For example, the alignment key area AKA may be surrounded (e.g., entirely surrounded) by the alignment key peripheral area APA in a plan view.

According to one or more embodiments, the insulating portion ISP may have one or more suitable shapes. For example, the insulating portion ISP may have a variety of visually identifiable shapes that allow it to function as an alignment key. For example, the insulating portion ISP may have a polygonal shape in a plan view. However, the present disclosure is not limited thereto. For example, the insulating portion ISP may have a curvilinear shape (e.g., a circle or ellipse shape) in a plan view.

The dummy pattern portion DUP formed around the periphery of the insulating portion ISP may be formed around the periphery of the substrate exposure area SEA. The substrate exposure area SEA may refer to a portion of the upper surface of the substrate SUB on which the dummy pattern portion DUP, the insulating portion ISP, and the trench insulating portion TRI are not formed. For example, a substrate exposure area SEA may refer to an area where the upper surface of the base portion BS is exposed.

According to one or more embodiments, the dummy pattern portion DUP may form a mesh structure in a plan view. For example, the dummy pattern portion DUP may include a first portion extending in a first direction DR1 and a second portion extending in a second direction DR2, and the first and second portions may intersect each other.

According to one or more embodiments, the insulating portion ISP may have a shape that covers an area in a plan view and, unlike the dummy pattern portion DUP, may cover the alignment key area AKA continuously. Accordingly, the insulating portion ISP may be visually identifiable.

Referring to FIGS. 6 and 7, a cross-sectional structure of a display panel DP (or display device 100) including a trench insulating portion TRI and an insulating portion ISP is disclosed.

According to one or more embodiments, in the display area DA, a substrate SUB and a pixel circuit layer PCL may be formed with sub-pixel circuits and wiring electrically connected to the sub-pixel circuits.

The substrate SUB may include a base portion BS, a well WL, dummy pattern portions DUP and a trench insulating portion TRI.

The base portion BS may be formed across a display area DA and a peripheral area PA. The base portion BS may form the base of the substrate SUB. The base portion BS may be other portions of the substrate SUB that exclude insulating portions ISP, wells WL, trench insulating portions TRI, dummy pattern portions DUP.

The base portion BS may surround at least a portion of each of the wells WL, the trench insulating portion TRI, the dummy pattern portion DUP, and the insulating portion ISP. If the substrate SUB is a silicon substrate, the base portion BS may include silicon and may not include silicon oxide.

According to one or more embodiments, at least a portion of the base portion BS may not be covered by the dummy pattern portion DUP in the alignment key peripheral area APA, for example, may be the substrate exposure area SEA.

The wells WL may be arranged in the display area DA. The wells WL may be formed by an ion implantation process in the substrate SUB, which may be a silicon substrate. The wells WL may form at least a portion of the transistors of the sub-pixel SP. For example, a portion of the wells WL (e.g., a first well portion) may form a source area of the transistors (e.g., circuit elements) of the sub-pixels SP, another portion of the wells WL (e.g., a second well portion) may form a drain area of the transistors of the sub-pixels SP, and yet another portion of the wells WL (e.g., a third well portion) may form a channel area of the transistors of the sub-pixels SP.

Each of the source area and drain area of the wells WL may be electrically connected to at least one of the conductive layers CL by a contact portion penetrating the insulating layer INS. At least a portion of the conductive layers CL may be arranged in a region overlapping the channel area of the well WL to form a gate electrode. Accordingly, the wells WL may form at least a portion of a transistor.

According to one or more embodiments, a plurality of wells WL may be formed in the substrate SUB. The plurality of wells WL may each form a portion of a circuit element, and thus may be electrically spaced apart from each other.

The trench insulating portion TRI may be arranged in the display area DA. The trench insulating portion TRI may be arranged between adjacent wells WL.

The trench insulating portion TRI may be arranged between the wells WL in a plan view. The trench insulating portions TRI and the wells WL may be spaced apart from each other in a direction extending from the plane in which the substrate SUB is arranged (e.g., horizontally).

The trench insulation portion TRI may include an insulating material. For example, the trench insulation portion TRI may include silicon oxide (SixOy). According to one or more embodiments, the substrate SUB (or base portion BS) may include a silicon material and the trench insulation portion TRI may include silicon oxide SixOy. According to one or more embodiments, the trench insulation portion TRI may be formed by oxidizing a portion of the substrate SUB that is a silicon substrate, or the trench insulation portion TRI may be formed by disposing silicon oxide (SixOy) after removing a portion of the substrate SUB. The present disclosure is not limited thereto.

The trench insulating portion TRI may have a trench shape and may extend longer in a downward direction (e.g., from the upper surface of the substrate SUB toward the bottom surface) relative to the wells WL. For example, the trench insulating portion TRI may provide more effective electrical isolation between adjacent wells WL, which may improve the operational reliability of the transistors.

According to one or more embodiments, the upper surface of the trench insulating portion TRI may contact the bottom surface of the insulating layer INS.

According to one or more embodiments, the insulating portion ISP may be formed in the alignment key area AKA in the peripheral area PA.

The insulating portion ISP may include a same material as the trench insulating portion TRI. For example, the insulating portion ISP may include silicon oxide (SixOy). According to one or more embodiments, the substrate SUB (or base portion BS) may include a silicon material and the insulating portion ISP may include silicon oxide SixOy.

The insulating portion ISP may be manufactured by any of the manufacturing methods discussed with reference to the trench insulating portion TRI, but the present disclosure is not limited thereto.

The insulating portion ISP may have a trench shape. The insulating portion ISP may extend along the thickness direction of the substrate SUB at a depth similar to the trench insulating portion TRI.

The insulating portion ISP may be arranged between the dummy pattern portions DUP in a plan view. The insulating portion ISP and the dummy pattern portion DUP may be spaced apart from each other in a direction extending from the plane in which the substrate SUB is arranged (e.g., horizontally).

According to one or more embodiments, the upper surface of the insulating portion ISP may be in contact with the bottom surface of the insulating layer INS. For example, the upper surface of the insulating portion ISP may be in contact with an insulating layer INS that directly covers at least a portion of the base portion BS.

According to one or more embodiments, the dummy pattern portion DUP may be arranged in the peripheral area PA, and may be arranged in the alignment key peripheral area APA.

The dummy pattern portion DUP may include the same insulating material as the trench insulating portion TRI. For example, the dummy pattern portion DUP may include silicon oxide (SixOy).

The dummy pattern portion DUP may be manufactured by any of the manufacturing methods discussed with reference to the trench insulating portion TRI, but the present disclosure is not limited thereto.

The dummy pattern portion DUP may extend along the thickness direction of the substrate SUB at a similar depth as the trench insulating portion TRI.

According to one or more embodiments, portions of the dummy pattern portion DUP that are horizontally adjacent to each other may be spaced apart by a dummy separation distance DSL. According to one or more embodiments, portions of the trench insulating portions TRI that are horizontally adjacent to each other may be spaced apart by a trench separation distance TL.

According to one or more embodiments, the dummy separation distance DSL and the trench separation distance TL may correspond to each other. For example, the dummy separation distance DSL and the trench separation distance TL may be a same (e.g., substantially a same) as each other. Accordingly, similar to the arrangement of the trench insulating portion TRI in the display area DA, the dummy pattern portion DUP may be arranged in the peripheral area PA.

According to one or more embodiments, the upper surface of the dummy pattern portion DUP may be in contact with the bottom surface of the insulating layer INS.

According to one or more embodiments, the pixel circuit layer PCL may include an insulating layer INS, conductive layers CL, interlayer insulating layers ILD, and an upper reflective layer URL arranged in each of the display area DA and the peripheral area PA.

According to one or more embodiments, a sub-pixel circuit may be arranged on a substrate SUB. The circuit elements of the sub-pixel circuit may be patterned on the substrate SUB.

According to one or more embodiments, the conductive layers CL may form electrodes electrically connected to the source or drain areas of the transistors of the sub-pixel circuit, and may form the gate electrodes of the transistors.

For example, at least a portion of the conductive layers CL may be electrically connected to the wells WL by contact members that penetrate the insulating layer INS. At least some of the conductive layers CL may be electrically connected to each other via contact members that penetrate at least some of the interlayer insulating layers ILD.

According to one or more embodiments, the conductive layers CL may form at least a portion of the lines electrically connected to the sub-pixel circuitry. For example, the conductive layers CL may form at least a portion of each of one or more suitable wiring lines (e.g., gate lines, light emission control lines, or power lines) electrically connected to the sub-pixel SP.

According to one or more embodiments, the conductive layers CL may be formed in n layers. The conductive layers CL may include a first conductive layer CL1, a second conductive layer CL2, ... an (n-1)th conductive layer CLn-1, and an (n)th conductive layer CLn. Wherein 'n' may be a natural number of 3 or more. The conductive layers CL may be formed in a plurality of layers, whereby many conductive layers CL may be patterned in a small area, thereby improving the integration of the sub-pixel circuit.

According to one or more embodiments, the insulating layer INS may be arranged on the substrate SUB. The interlayer insulating layer ILD may cover at least a portion of the conductive layers CL. The interlayer insulation layer ILD may be formed in m layers. The interlayer insulating layer ILD may include a first interlayer insulating layer ILD1, a second interlayer insulating layer ILD2, ... a (m-1)th interlayer insulating layer ILDm-1, and a (m)th interlayer insulating layer ILDm. Here, 'm' may be a natural number greater than or equal to 3. The nth conductive layer CLn may be covered by the (m)th interlayer insulating layer ILDm. The insulating layer INS and the interlayer insulating layer ILD may include at least one or more suitable inorganic materials or one or more suitable organic materials, and the present disclosure is not limited thereto.

The upper reflective layer URL may be arranged on the conductive layers CL. For example, the upper reflective layer URL may be spaced further from the substrate SUB than the conductive layers CL.

According to one or more embodiments, the upper reflective layer URL may be arranged on an interlayer insulating layer ILD (e.g., a mth interlayer insulating layer ILDm). The upper reflective layer URL may be electrically connected to at least some of the conductive layers CL, thereby electrically connecting the sub-pixel circuitry and the anode electrodes AE of the light-emitting elements LD in the display area DA.

The upper reflective layer URL may function as a reflective electrode for the light-emitting element LD in the display area DA. The upper reflective layer URL may include a reflective conductive material. For example, the upper reflective layer URL may include at least one of copper, silver, aluminium, nickel, gold, palladium, molybdenum, or platinum. However, the present disclosure is not limited thereto. For example, at least a portion of the upper reflective layer URL may overlap with the light-emitting element LD in a plan view, and may recycle light provided by the light-emitting element LD.

According to one or more embodiments, the conductive layer CL may include copper and the upper reflective layer URL may include aluminium. However, the present disclosure is not limited thereto.

According to one or more embodiments, the insulating portion ISP in the alignment key area AKA may overlap the conductive layer CL in a plan view. According to one or more embodiments, the insulating portion ISP in the alignment key area AKA may overlap with the upper reflective layer URL in a plan view.

According to one or more embodiments, the insulating portion ISP formed of an insulating material may be visually identifiable in one area to constitute the alignment key feature, and one or more reflective structures having reflective properties may be formed on top of the insulating portion ISP.

For example, at least a portion of the conductive layer CL in the alignment key area AKA may form a reflective structure. According to one or more embodiments, at least a portion of the upper reflective layer URL in the alignment key area AKA may form a reflective structure.

Experimentally, if (e.g., when) the alignment key structure including the conductive material functions as an alignment key, it is necessary that the circuit elements and wiring, and/or the like are not patterned in an area overlapping with the alignment key structure in a plane in order for light to be clearly applied to the alignment key structure to identify the location of the alignment key structure.

For example, if an alignment key structure formed from a conductive material is patterned in a shape and circuit elements and wiring are patterned on a lower or upper part of the alignment key structure, the location of the alignment key structure may be difficult to identify.

For example, areas where circuit elements and wiring are not arranged may be formed in the display panel DP, thereby increasing the non-display area NDA (e.g., dead space).

However, in one or more embodiments, the insulating portion ISP arranged to perform the alignment key function may be configured to include an insulating material rather than a conductive material.

In one or more embodiments, circuit elements and wiring may be arranged in areas that overlap in plan with the insulating portion ISP, and space on the substrate SUB may be efficiently utilized. The non-display area NDA (e.g., dead space) may be reduced to form a large area of display area DA.

Furthermore, the design flexibility of the upper reflective layer URL and the conductive layers CL on the substrate SUB may be improved, and the integration density of the layers on the substrate SUB may be improved as the upper reflective layer URL and the conductive layers CL are efficiently patterned in the space. In such a case, circuit elements and wiring in a small area may be efficiently patterned, and a high-resolution and high-quality display device 100 may be provided.

According to one or more embodiments, in order to determine the position of the display panel DP including the insulating portion ISP during the manufacturing process of the display device 100, light may be applied to the insulating portion ISP, and the insulating portion ISP may function as an alignment key.

When light is applied to the display panel DP, a greater amount of light may be transmitted to the area covered by the insulating portion ISP.

Accordingly, a greater amount of light may be applied to the alignment key area AKA where the insulating portion ISP is arranged, and the applied light may be reflected by the conductive layer CL and/or the upper reflective layer URL.

Accordingly, the area in which the insulating portion ISP is arranged may be visually identified such that the area in which the insulating portion ISP is arranged may perform the function of an alignment key.

Referring to FIGS. 8-11, a method of manufacturing the display device 100 according to one or more embodiments will be described. For the sake of simplicity of description, details that may be redundant to the foregoing will be briefly described or not repeated.

FIG. 8 is a schematic plan view illustrating some process steps of a method of manufacturing a display device according to one or more embodiments. A mother substrate MS including a plurality of cells CEL is provided, and FIG. 8 schematically illustrates a process step (e.g., act or task) prior to the plurality of cells CEL being separated from each other.

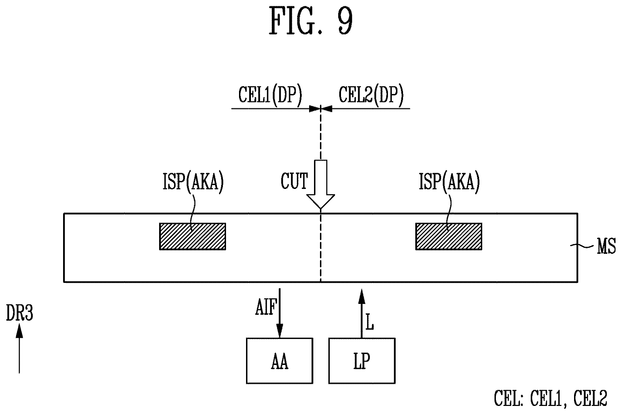

FIG. 9 is a schematic cross-sectional view illustrating some process steps of a method of manufacturing a display device according to one or more embodiments. FIG. 9 schematically illustrates a mother substrate MS including a plurality of cells CEL, a process for separating the plurality of cells CEL from each other, and a process for determining a position of the plurality of cells CEL (or display panel DP).

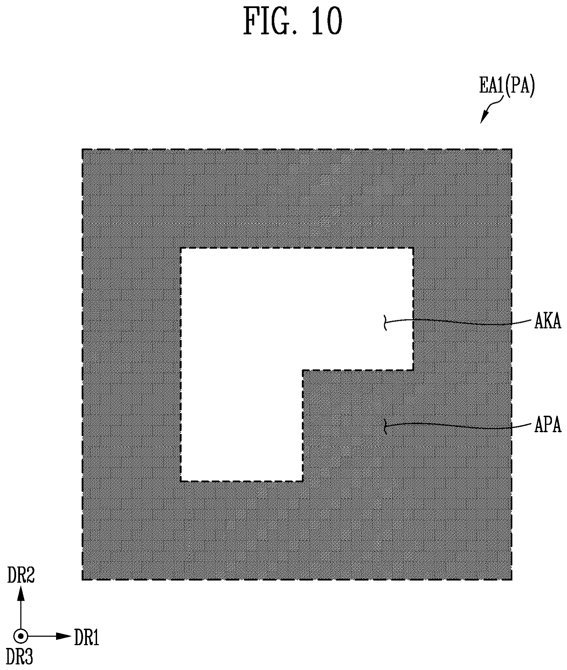

FIG. 10 is a schematic plan view illustrating some process steps of a method of manufacturing a display device according to one or more embodiments. FIG. 10 illustrates a same area as the top view of FIG. 5, and schematically illustrates an alignment key area AKA being visually identified by light L applied by a light providing portion LP.

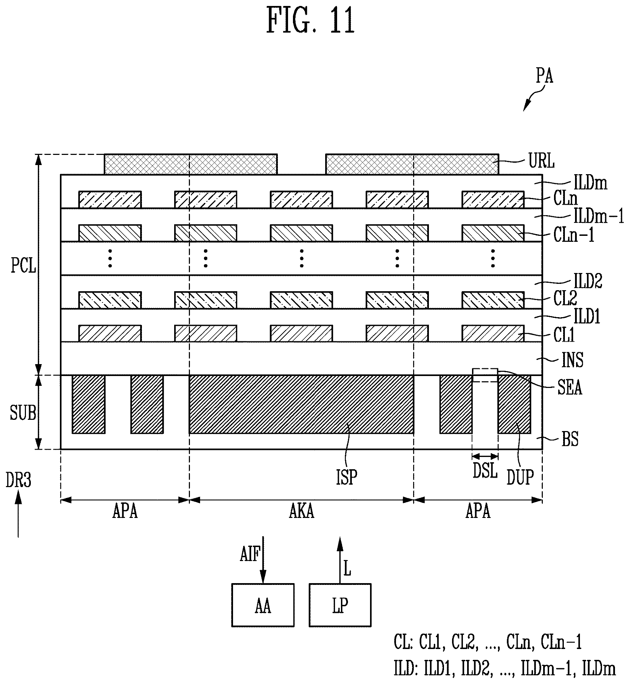

FIG. 11 is a schematic cross-sectional view illustrating some process steps of a method of manufacturing a display device according to one or more embodiments. FIG. 11 shows a same area as the cross-sectional view of FIG. 7, and schematically illustrates a structure in which the conductive layers CL and the upper reflective layer URL are arranged in the alignment key area AKA such that the alignment key area AKA may be visually identified by light L applied by the light providing part LP.

A method of manufacturing the display device 100 (or display panel DP) according to one or more embodiments may include the steps of providing a plurality of cells CEL on a mother substrate MS and separating the plurality of cells CEL to provide individually arranged cells CEL.

Referring to FIGS. 8 and 9, in the step (e.g., act or task) of providing the plurality of cells CEL on the mother substrate MS, the mother substrate MS may have (include) a plurality of cells CEL in the mother substrate MS that each form a display panel DP.

For example, a pixel circuit layer PCL and a light-emitting element layer LDL and/or the like may be arranged on the substrate SUB forming the display panel DP. For example, each display panel DP may include the pixel circuit layer PCL and the light-emitting element layer LDL arranged on the substrate SUB. The process for disposing the components on the substrate SUB may include one or more suitable processes used in semiconductor processes suitable in the art.

According to one or more embodiments, each cell CEL forming the display panel DP may include an insulating portion ISP formed in an alignment key area AKA.

Referring to FIGS. 8-11, in a step (e.g., act or task) of separating the plurality of cells CEL to provide individually arranged cells CEL, the position of the plurality of cells CEL (e.g., display panels DP) may be determined in order to cut at least a portion of the mother substrate MS. Referring to FIG. 9, the plurality of cells CEL may include a first cell CEL1 and a second cell CEL2.

For example, the light providing portion LP may apply light L to the cells CEL (or display panels DP). According to one or more embodiments, if (e.g., when) the light L is directed toward the backside of the substrate SUB, the alignment key area AKA may be perceived as brighter than the area around the alignment key area AKA. Accordingly, a set or predetermined visually recognizable pattern may be identified depending on the shape of the insulating portion ISP.

When light L is applied to the alignment key area AKA, only a portion of the light L may be absorbed by the substrate SUB and most of the light L may be reflected by the conductive layers CL and/or the upper reflective layer URL on the substrate SUB. As a result, the area where the insulating portion ISP is arranged in the alignment key area AKA may be brightly visible.

When light L is applied to the alignment key peripheral area APA (e.g., an area around the alignment key area AKA), most of the light L may be absorbed by the substrate SUB and no light may be applied to the conductive layers CL and/or the upper reflective layer URL on the substrate SUB. As a result, the area in the alignment key peripheral area APA may appear dark.

For example, the image provided by the reflection of the light L applied to the alignment key area AKA may include alignment information AIF. Therefore, as the light L is applied to the cells CEL, the reflected light having the alignment information AIF including the position information of each cell CEL may be applied to the optical information providing portion AA, and accordingly, the positions of the cells CEL may be reliably identified.

According to one or more embodiments, the insulating portion ISP may be to transmit light L at a higher rate compared to the other part of the substrate SUB, the base portion BS.

According to one or more embodiments, the light L may have an infrared wavelength band. For example, the light L may have a wavelength of 1150 nm or less. For example, the light L may have a wavelength range of 900 nm to 1150 nm.

According to one or more embodiments, the insulating portion ISP may include silicon oxide and the base portion BS may include silicon. Experimentally, silicon may absorb light in a wavelength of about 1150 nm or less. The silicon oxide may transmit light in a wavelength of about 1150 nm or less. For example, the silicon may absorb light having a wavelength of about (approximately) 1150 nm or less, while the silicon oxide may transmit light within the same wavelength range.

This is due to the difference in bandgap energy between silicon and silicon oxide. For example, silicon has a bandgap energy of about (approximately) 1.1 eV, while silicon oxide has a bandgap energy of about (approximately) 9 eV. The difference between the bandgap energy of the applied aspect (or material) and the bandgap energy of the light results in the tendency for light to be absorbed or transmitted. Due to the aforementioned bandgap energy values of silicon and silicon oxide, the transmission/absorption of silicon and silicon oxide may differ for light in the wavelength of about 1150 nm or less.

According to one or more embodiments, light L in a wavelength band in which silicon and silicon oxide are differently transmissive or absorptive may be utilized to enable the insulating portion ISP to perform an alignment key function.

According to one or more embodiments, the cells CEL (e.g., the display panel DP) may include the insulating portion ISP that performs the alignment key function, and accordingly, no structure for performing the alignment key function may be arranged on the mother substrate MS. Accordingly, space on the mother substrate MS may be utilized efficiently, and process costs may be reduced. For example, the space of the mother substrate MS may be efficiently utilized, and the number of cells CEL comprised in the mother substrate MS may be increased, thereby improving process efficiency.

Referring to FIGS. 10 and 11, in the alignment key area AKA, an insulating portion ISP including silicon oxide is arranged continuously over a wide area, so that if (e.g., when) light L is applied, most of the light L may penetrate the substrate SUB and be output to the outside by the conductive layers CL in the pixel circuit layer PCL or the upper reflective layer URL.

In comparison, in the alignment key peripheral area APA, a dummy pattern portion DUP may be arranged in some areas, and a substrate exposure area SEA may be formed in many areas, such that the base portion BS may extend in the direction of the thickness of the substrate SUB. Accordingly, if (e.g., when) light L is applied to the alignment key peripheral area APA, the light L may be absorbed by the base portion BS including silicon, and the light L applied to the alignment key peripheral area APA may be relatively invisible to the outside.

Accordingly, the insulating portion ISP in the alignment key area AKA may be visually identifiable using light L and may function as an alignment key.

According to one or more embodiments, the location of the cells CEL may be clearly determined, and a cutting process (e.g., a cutting process using a blade, and/or the like) may be closely followed to separate the cells CEL from each other. At least a portion of the mother substrate MS may be cut, and a separately prepared display panel DP may be provided, and by further processing the display panel DP, a display device 100 according to one or more embodiments may be provided.

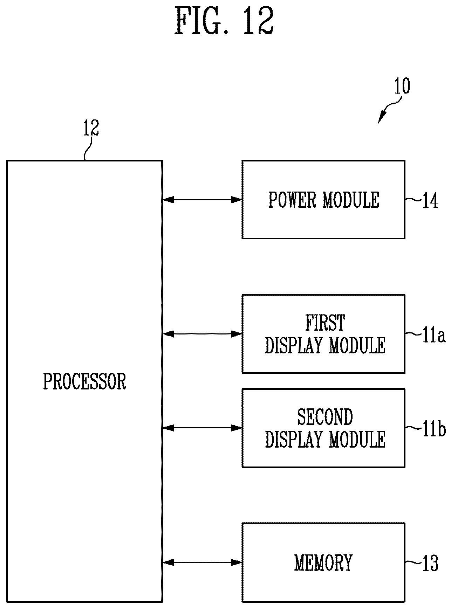

FIG. 12 is a block diagram of an electronic device according to one or more embodiments.

Referring to FIG. 12, the electronic device 10 may include first and second display modules 11a, 11b, a processor 12, a memory 13, and a power module 14.

The processor 12 may include at least one of a central processing unit (CPU), an application processor (AP), a graphics processing unit (GPU), a communication processor (CP), an image signal processor (ISP), or a controller.

The memory 13 may store data desired or required for operation of the processor 12 or the first and second display modules 11a, 11b. When the processor 12 executes an application stored in the memory 13, image data and control signals are delivered to the first and second display modules 11a, 11b. The first and second display modules 11a, 11b may process the received image data and control signals to output image information via the sub-pixels SP.

The power module 14 may include a power supply module, such as a power adapter or battery unit, and a power conversion module that converts the power supplied by the power supply module to generate the power desired or required for operation of the electronic device 10.

In FIG. 12, the electronic device 10 is shown to include first and second display modules 11a, 11b. However, embodiments are not limited thereto, and the electronic device 10 may include one display module or three or more display modules.

At least one of the above-described configurations of the display device may be comprised in the electronic device 10 according to one or more embodiments. Furthermore, some of the individual modules that are functionally comprised in one module may be comprised in the display device and others may be provided separately from the display device. For example, the display device may include first and second display modules 11a, 11b, while the processor 12, memory 13, and power module 14 may be provided in the form of other devices in the electronic device 10 other than the display device. For example, the display device according to the one or more embodiments may be provided as each of the first and second display modules 11a, 11b.

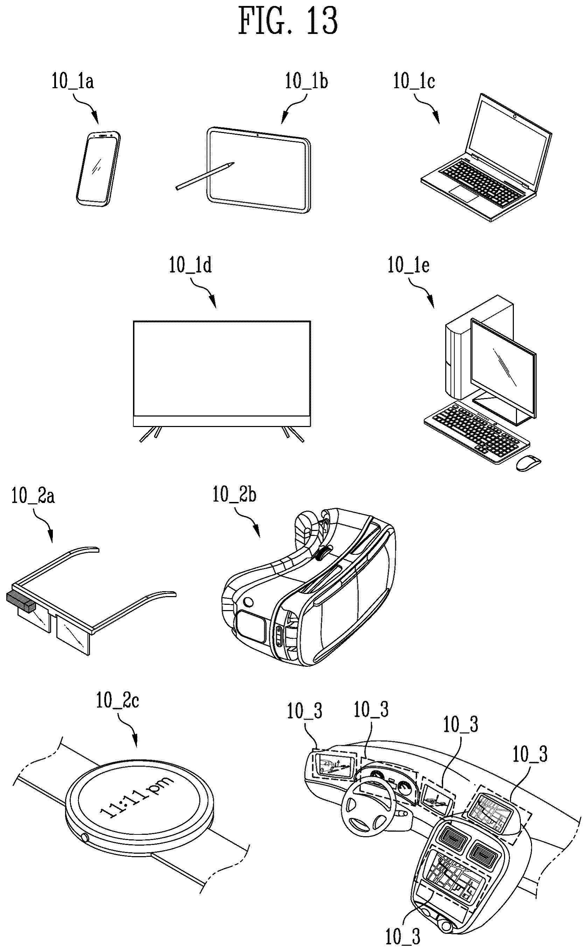

FIG. 13 is a set of drawings illustrating one or more embodiments of the electronic device.

Referring to FIG. 13, one or more suitable types (kinds) of electronic devices with display devices to which one or more embodiments may be applied include: electronic devices for displaying images, such as smartphones 10_1a, tablet PCs 10_1b, laptops 10_1c, televisions 10_1d, desk monitors 10_1e; a wearable electronic device including a display module, such as smart glasses 10_2a, head-mounted displays 10_2b, smart watches 10_2c, and/or the like; and/or automotive electronic devices 10_3 that include display modules such as center information displays (CIDs), room mirror displays, and/or the like arranged on the instrument panel, center fascia, or dashboard of an automobile, and/or the like.

If the electronic device is implemented as a head-mounted display 10_2b, the head-mounted display 10_2b may include first and second display modules 11a, 11b, as described with reference to FIG. 12. The first display module 11a may provide an image to the user's right eye, and the second display module 11b may provide an image to the user's left eye. In such cases, the head-mounted display 10_2b may further include a right-eye lens configured to refract light from the first display module 11a toward the right eye of the user, and a left-eye lens configured to refract light from the second display module 11b toward the left eye of the user. According to one or more embodiments, each of the right eye lens and the left eye lens may include an optical lens having a pancake-shaped cross-section. According to one or more embodiments, each of the right eye lens and the left eye lens may include a multi-channel lens including sub-areas having different optical properties. In such cases, each display panel may output images corresponding to each of the sub-areas of the multi-channel lens, and the output images may pass through each of the sub-areas and be displayed to the user.

Although certain embodiments and applications have been described herein, other embodiments and modifications may be derived from the above description. Accordingly, the ideas of the present invention are not limited to these embodiments, but extend to the patent claims, one or more suitable obvious variations, and equivalents set forth below.

## Claims

1. A display device (100) comprising:
an insulating portion (ISP) configured to function as an alignment key and comprising an insulating material.

2. The display device (100) of claim 1, comprising:
an alignment key area (AKA); and
an alignment key peripheral area (APA) around at least a portion of the alignment key area (AKA),
wherein the insulating portion (ISP) is arranged in the alignment key area (AKA).

3. The display device (100) of claim 2, wherein the alignment key area (AKA) is entirely surrounded by the alignment key peripheral area (APA) and has an isolated shape.

4. The display device (100) of claim 3, wherein the insulating portion (ISP) has a shape covering an area and has a visually identifiable shape.

5. The display device (100) of any one of claims 2 to 4, further comprising:
a substrate (SUB); and
a conductive layer (CL) on the substrate (SUB),
wherein at least a portion of the insulating portion (ISP) is recessed into the substrate (SUB) in a thickness direction of the substrate (SUB).

6. The display device (100) of claim 5, wherein the conductive layer (CL) comprises a reflective conductive material and is arranged to overlap the insulating portion (ISP) in a plan view, optionally wherein the conductive layer (CL) is arranged over the alignment key area (AKA) and the alignment key peripheral area (APA).

7. The display device (100) of claim 6, further comprising:
an upper reflective layer (URL) arranged on the conductive layer (CL),
wherein the conductive layer (CL) comprises a plurality of layers, and
wherein the insulating portion (ISP) is arranged to overlap at least one of the upper reflective layer (URL) and the conductive layer (CL) in a plan view, optionally wherein the conductive layer (CL) comprises copper and the upper reflective layer (URL) comprises aluminium.

8. The display device (100) of any one of claims 5 to 7, wherein the substrate (SUB) comprises a base portion (BS) around at least a portion of the insulating portion (ISP) and forming a base of the substrate (SUB),
wherein the base portion (BS) comprises a silicon material, and does not comprise silicon oxide, and
wherein the insulating portion (ISP) comprises a silicon oxide.

9. The display device (100) of claim 8, wherein:
(i) the insulating portion (ISP) transmits light having a wavelength of 1150 nm or less, and wherein the base portion (BS) absorbs the light; and/or
(ii) the display device (100) further comprises:
an insulating layer (INS) directly covering at least a portion of the base portion (BS),
wherein an upper surface of the insulating portion (ISP) is in contact with the insulating layer (INS).

10. The display device (100) of claim 8 or claim 9, further comprising a dummy pattern portion (DUP) arranged in the alignment key peripheral area (APA),
wherein the insulating portion (ISP) and the dummy pattern portion (DUP) comprise a same insulating material.

11. The display device (100) of claim 10, wherein:
(i) an upper surface of the base portion (BS) is not completely covered by the dummy pattern portion (DUP) in the alignment key peripheral area (APA); and/or
(ii) the dummy pattern portion (DUP) forms a mesh structure in a plan view.

12. The display device (100) of any one of claims 8 to 11, further comprising:
a sub-pixel circuit on the substrate (SUB); and
a light-emitting element (LD) electrically connected to the sub-pixel circuit,
wherein at least a portion of the conductive layer (CL) arranged in the alignment key area (AKA) forms at least a portion of a circuit element of the sub-pixel circuit and at least a portion of a wiring electrically connected to the sub-pixel circuit.

13. The display device (100) of claim 12, wherein the substrate (SUB) further comprises trench insulating portions (TRI) and a well (WL) between the trench insulating portions (TRI),
wherein the well (WL) forms a source area, a drain area, and a channel area of the circuit element, and
wherein the trench insulating portions (TRI) comprise a same material as the insulating portion (ISP), optionally wherein the trench insulating portions (TRI) extend longer in a downward direction relative to the well (WL).

14. A display device (100) comprising:
a substrate (SUB) comprising silicon, an alignment key being embedded in the substrate (SUB); and
a light-emitting element (LD) on the substrate (SUB) and comprising an organic light-emitting element (LD).

15. An electronic device (10) comprising:
a processor (12); and
a display device (100) configured to receive image data from the processor (12), the display device comprising an insulating portion (ISP) configured to function as an alignment key and comprising an insulating material.
